# EUROPÄISCHE PATENTSCHRIFT

(11) **EP 2 210 073 B1**
(45) Veröffentlichungstag und Bekanntmachung des Hinweises auf die Patenterteilung: **17.05.2017**
(21) Anmeldenummer: 08846593.5
(22) Anmeldetag: 30.10.2008
(51) Int. Cl.: G01J 5/60

(54) **SCHALTUNGSANORDNUNG ZUM ERZEUGEN VON LICHT- UND TEMPERATURABHÄNGIGEN SIGNALEN, INSBESONDERE FÜR EIN BILDGEBENDES PYROMETER**
CIRCUIT ARRANGEMENT FOR CREATING LIGHT AND TEMPERATURE DEPENDANT SIGNALS, PARTICULARLY FOR AN IMAGING PYROMETER
CIRCUITERIE POUR LA PRODUCTION DE SIGNAUX DÉPENDANT DE LA LUMINOSITÉ ET DE LA TEMPÉRATURE, NOTAMMENT POUR UN PYROMÈTRE PRODUISANT DES IMAGES

(30) Priorität: 05.11.2007 DE 102007054314
(43) Veröffentlichungstag der Anmeldung: 28.07.2010
(73) Patentinhaber: INSTITUT FÜR MIKROELEKTRONIK STUTTGART, 70569 Stuttgart (DE)
(72) Erfinder: BURGHARTZ, Joachim, N., 70771 Leinfelden-Echterdingen (DE); HUTTER, Franz, Xaver, 78166 Donaueschingen (DE); BROSCH, Daniel, 72760 Reutlingen (DE); GRAF, Heinz-Gerhard, 71106 Magstadt (DE)
(74) Vertreter: Witte, Weller & Partner Patentanwälte mbB
(86) Internationale Anmeldenummer: PCT/EP2008/009167
(87) Internationale Veröffentlichungsnummer: WO 2009/059721

(56) Entgegenhaltungen:
- EP-A- 1 134 565
- EP-A- 1 630 871
- DE-A1-102006 013 168
- MALDAGUE X ET AL: "DUAL IMAGER AND ITS APPLICATIONS TO ACTIVE VISION ROBOT WELDING, SURFACE INSPECTION, AND TWO-COLOR PYROMETRY" OPTICAL ENGINEERING, SOC. OF PHOTO-OPTICAL INSTRUMENTATION ENGINEERS. BELLINGHAM, Bd. 28, Nr. 8, 1. August 1989 (1989-08-01), Seiten 872-880, XP000047273 ISSN: 0091-3286

## Beschreibung

Die vorliegende Erfindung betrifft eine Schaltungsanordnung zum Erzeugen von licht- und temperaturabhängigen Signalen, die Eigenschaften einer Szene repräsentieren, mit Sensorelementen, die in Abhängigkeit von auftreffender elektromagnetischer Strahlung eine Anzahl von ersten und zweiten elektrischen Signalen erzeugen, wobei die ersten elektrischen Signale in Abhängigkeit von elektromagnetischer Strahlung aus einem ersten Wellenlängenbereich erzeugt sind, der zumindest einen großen Teil des sichtbaren Lichts enthält, und wobei die zweiten elektrischen Signale in Abhängigkeit von elektromagnetischer Strahlung aus einem zweiten Wellenlängenbereich erzeugt sind, der überwiegend Infrarotstrahlung enthält, wobei der erste Wellenlängenbereich den zweiten Wellenlängenbereich überlappt und somit ebenfalls Infrarotstrahlung enthält.

Eine solche Schaltungsanordnung ist aus DE 10 2006 013 168 A1 bekannt.

EP 1 134 565 B1. beschreibt ein bildgebendes Pyrometer, mit dessen Hilfe sich Oberflächentemperaturverteilungen von Objekten in einer beobachteten Szene bestimmen lassen. Außerdem liefert dieses bekannte Pyrometer ein "normales" optisches Bild der Szene. Erreicht wird dies, indem das bekannte Pyrometer einen optoelektronischen Sensor mit einer Vielzahl von Sensorelementen besitzt, die in der Druckschrift als Pixel bezeichnet sind. Der optoelektronische Sensor besitzt drei verschiedene Arten von Sensorelementen, die an der Oberfläche des Sensors abwechselnd angeordnet sind. Eine erste Art von Sensorelementen ist dazu ausgebildet, elektrische Signale in Abhängigkeit von elektromagnetischer Strahlung zu erzeugen, die aus einem sehr schmalbandigen Wellenlängenbereich um 1,06 µm stammt. Eine zweite Art von Sensorelementen ist dazu ausgebildet, elektrische Signale in Abhängigkeit von elektromagnetischer Strahlung aus einem zweiten schmalbandigen Wellenlängenbereich um 0,99 µm zu erzeugen. Die beiden schmalbandigen Wellenlängenbereiche enthalten jeweils einen geringen Teil des infraroten Spektrums. Eine dritte Art von Sensorelementen ist dazu ausgebildet, elektrische Signale in Abhängigkeit von elektromagnetischer Strahlung aus einem relativ breitbandigen Wellenlängenbereich zu erzeugen, der im Wesentlichen nur das sichtbare Licht enthält. Die elektrischen Signale aus den beiden Infrarotbereichen werden dazu verwendet, Temperaturen nach einem Algorithmus zu bestimmen, wie er beispielsweise in US 4,413,324 beschrieben ist. Es handelt sich dabei um ein Quotientenverfahren, bei dem ein Quotient der Signale aus den beiden schmalbandigen Infrarotbereichen gebildet wird, um die Emissionseigenschaften der Oberfläche, deren Temperatur bestimmt wird, zu eliminieren. Mit Hilfe der dritten elektrischen Signale aus dem Wellenlängenbereich des sichtbaren Lichts wird lediglich das "normale" optische Bild von der beobachteten Szene erzeugt.

Der bekannte Sensor besitzt also drei verschiedene Arten von Sensorelementen, die auf zumindest teilweise unterschiedliche Prozessschritte hergestellt und auf der Oberfläche des Sensors verteilt werden müssen. Infolgedessen ist die Herstellung des bekannten Sensors recht aufwändig und teuer. Andererseits ist die Auflösung des bekannten Sensors sowohl in Bezug auf das visuelle Bild als auch in Bezug auf die Temperaturverteilung begrenzt, weil die verschiedenen Sensorelemente nebeneinander auf der Oberfläche des Sensors angeordnet sind, so dass zwischen zwei Sensorelementen gleichen Typs jeweils "Lücken" bestehen, die von Sensorelementen eines anderen Typs belegt sind. Die begrenzte Auflösung ist von Nachteil, wenn man beispielsweise anhand des optischen Bildes geometrische Eigenschaften eines aufgenommenen Objekts bestimmen möchte. Schließlich ist auch der Dynamikbereich der Sensorelemente bei dem bekannten Sensor begrenzt, so dass in Abhängigkeit von den Temperaturen und Strahlungsstärken in der beobachteten Szene unterschiedliche Belichtungszeiten benötigt werden. Infolgedessen kann die Bildaufnahme problematisch sein.

Die bereits zitierte US 4,413,324 offenbart ein Quotientenpyrometer mit einer Vielzahl von Sensorelementen, die elektromagnetische Strahlung in zwei verschiedenen, jeweils schmalbandigen Wellenlängenbereichen aufnehmen. Das bekannte Pyrometer ermöglicht die Bestimmung einer Temperaturverteilung, nicht jedoch die Aufnahme eines "normalen" optischen Bildes der beobachteten Szene.

Quotientenpyrometer sind darüber hinaus seit vielen Jahren aus verschiedenen Druckschriften bekannt. Beispielsweise sei auf DE 12 37 804 A1 verwiesen, in der vorgeschlagen wird, die Messwerte zunächst zu logarithmieren, um dann eine Differenz der Logarithmen zu bilden, wobei diese Differenz dem Logarithmus des Quotienten entspricht. Vorgeschlagen ist hier, elektromagnetische Strahlung aus dem roten und dem blauen Wellenlängenbereich aufzunehmen. Ein ähnlicher Vorschlag findet sich auch in DE 867 453, wobei dort elektromagnetische Strahlung aus dem roten und dem grünen Wellenlängenbereich aufgenommen werden soll.

DE 24 27 892 A1 offenbart ein Quotientenpyrometer, bei dem die tatsächliche Temperatur in der Szene mit Hilfe eines separaten Temperaturstrahlers bestimmt wird, der einen Vergleichswert für die Temperaturbestimmung liefert.

DE 11 36 135 A offenbart ein Quotientenpyrometer, bei dem ein Fotoelement aus Silizium in Strahlrichtung vor einer Germaniumdiode angeordnet ist. Die Siliziumscheibe wirkt als Filterelement und lässt überwiegend nur Strahlung durch, deren Wellenlänge größer als 1,2 µm ist. Die Germaniumdiode besitzt eine maximale Empfindlichkeit im Wellenlängenbereich um 1,5 µm. Die maximale Empfindlichkeit des Fotoelements aus Silizium liegt bei etwa 0,9 µm. Aus den Signalen der beiden Sensorelemente wird die Temperatur in der beobachteten Szene bestimmt.

Aus DE 33 17 108 A1, ist ein Dünnfilm-Halbleiterbauteil bekannt, das z.B. als Solarzelle Verwendung findet. Das Dünnfilm-Halbleiterbauteil ist schichtweise auf einem Halbleitersubstrat aufgebaut.

Aus DE 196 50 705 A1 ist eine Kamera mit mehreren Sensorelementen bekannt, die stapelweise übereinander angeordnet sind. Beispielsweise sind ein Farbmatrixsensor und ein Schwarz-Weiß-Matrixsensor vertikal übereinander angeordnet und pixelweise zueinander ausgerichtet. Die in der Tiefe gestapelten pn-Übergänge der Sensoren reagieren auf unterschiedliche Wellenlängen, da optische Wellenlängen umso tiefer in das Material eindringen, je länger die Wellenlänge ist.

DE 10 2006 013 168 A1 offenbart eine weitere Vorrichtung mit einer CCD-Kamera zum berührungslosen Temperaturmessen von heißen Gegenständen. Die Druckschrift schlägt vor, ein drehbares Filterrad mit einer Anzahl von Filterscheiben vor der CCD-Kamera anzuordnen. Die Filterscheiben lassen nur einen bestimmten Wellenlängenbereich zu der CCD-Kamera hindurch. In einem Ausführungsbeispiel soll ein sog. Grünfilter verwendet werden, das Licht unterhalb einer definierten Wellenlänge durchlässt. Des Weiteren ist ein Rotfilter vorgeschlagen, dessen Spektralbereich sich mit dem Spektralbereich des Grünfilters zum Teil überlappen kann, wobei darauf geachtet werden soll, dass keine vollständige Überlappung auftritt. Im Gegenteil, bei allen anderen Ausführungsbeispielen betont die Druckschrift, dass die Spektralbereiche der Filter sich möglichst nicht überlappen sollen. Die verschiedenen Filter werden durch Drehen des Filterrades nacheinander vor der CCD-Kamera angeordnet.

Aus DE 42 09 536 A1 ist schließlich eine Bildzelle für einen Bildaufnehmerchip bekannt, bei der eine Photodiode und ein MOS-Transistor so miteinander verbunden sind, dass in der Photodiode generierte Ladungsträger durch den Kanal des MOS-Transistors abfließen. Der MOS-Transistor wird hier im so genannten Sub-Threshold-Bereich betrieben, was zur Folge hat, dass das elektrische Ausgangssignal der Bildzelle logarithmisch von der Intensität der auftreffenden Strahlung abhängt. Diese bekannte Bildzelle ermöglicht daher die Aufnahme hochdynamischer Lichtsignale. Kommerziell werden Bildaufnehrnerchips mit dieser Technologie unter der Marke HDAC® von der vorliegenden Anmelderin angeboten.

Vor dem Hintergrund dieses Standes der Technik ist es eine Aufgabe der vorliegenden Erfindung, eine Schaltungsanordnung zum Erzeugen von licht- und temperaturabhängigen Signalen anzugeben, mit deren Hilfe sich verschiedene Eigenschaften oder Merkmale von Objekten in einer Szene einschließlich strahlungsabhängiger Eigenschaften mit hoher Genauigkeit und auf kostengünstige Weise bestimmen lassen. Es ist insbesondere eine Aufgabe der Erfindung, eine Schaltungsanordnung anzugeben, mit der sich ein bildgebendes Pyrometer kostengünstig realisieren lässt.

Gemäß einem Aspekt der Erfindung wird diese Aufgabe durch eine Schaltungsanordnung der eingangs genannten Art gelöst, wobei die Sensorelemente eine Anzahl von ersten und zweiten Sensorelementen enthalten, wobei die ersten und zweiten Sensorelemente zwei verschiedene Arten von Sensorelementen sind, da sie zur Aufnahme von elektromagnetischer Strahlung aus verschiedenen Wellenlängenbereichen ausgebildet sind, wobei der erste Wellenlängenbereich den zweiten Wellenlängenbereich weitgehend vollständig überlappt, wobei das zweite Sensorelement ein Kantenfilter beinhaltet, das eine untere Grenze des zweiten Wellenlängenbereichs definiert, und wobei die untere Grenze im Wesentlichen mittig zu dem ersten Wellenlängenbereich liegt.

Die neue Schaltungsanordnung basiert auf dem an sich bekannten Konzept, elektromagnetische Strahlung aus zwei verschiedenen Wellenlängenbereichen aufzunehmen. Durch eine Quotientenbildung lässt sich dann die Oberflächentemperatur von Objekten in der beobachteten Szene bestimmen. Aufgrund der Quotientenbildung werden die Emissionseigenschaften der Oberfläche eliminiert. Im Gegensatz zu zahlreichen Schaltungsanordnungen aus dem Stand der Technik verwendet die neue Schaltungsanordnung jedoch zwei breitbandige Wellenlängenbereiche, die sich im Bereich der Infrarotstrahlung überlappen. Außerdem enthält der erste Wellenlängenbereich auch einen großen Teil des sichtbaren Lichts. Wie sich überraschend gezeigt hat, ist trotz der im Infrarotbereich überlappenden Wellenlängenbereiche eine Temperaturbestimmung nach dem bekannten Quotientenverfahren mit hoher Genauigkeit möglich. Zusätzlich liefert die neue Schaltungsanordnung auch Signale aus dem sichtbaren Wellenlängenbereich. Daher ermöglicht die neue Schaltungsanordnung nicht nur eine Temperaturbestimmung, sondern sie liefert auch Signale für die Erzeugung eines optischen Bildes (herkömmliches Kamerabild) der beobachteten Szene.

Im Gegensatz zu der eingangs genannten Schaltungsanordnung nach EP 1 134 565 B1 kommt die neue Schaltungsanordnung dabei mit zwei verschiedenen Arten von Sensorelementen aus. Sie ist folglich einfacher und kostengünstiger zu realisieren. In bevorzugten Ausführungsbeispielen sind die ersten Sensorelemente ohne spezielle Filter realisiert, d.h. sie nehmen elektromagnetische Strahlung aus dem gesamten Wellenlängenbereich auf, der mit den verwendeten Materialien prinzipiell detektierbar ist. Mit anderen Worten wird bei den ersten Sensorelementen bevorzugt auf zusätzliche Filter verzichtet, was eine besonders einfache und kostengünstige Realisierung ermöglicht.

Da lediglich zwei verschiedene Arten von Sensorelementen benötigt werden, können Sensorelemente gleichen Typs auf der Oberfläche eines matrixartigen Bildsensors dichter nebeneinander angeordnet werden, was eine höhere Auflösung ermöglicht. Infolgedessen lassen sich geometrische Eigenschaften eines beobachteten Objekts aus den aufgenommenen Bildern mit höherer Genauigkeit bestimmen. Prinzipiell kann die neue Schaltungsanordnung jedoch nicht nur bei matrixartigen Bildsensoren eingesetzt werden, sondern auch bei Pyrometern, die lediglich zwei Sensorelemente oder eine geringe Anzahl von ersten und zweiten Sensorelementen besitzen.

Außerdem ist der zweite Wellenlängenbereich ein Teilbereich des ersten Wellenlängenbereichs. Diese Ausgestaltung ermöglicht eine sehr einfache und kostengünstige Realisierung der ersten und zweiten Sensorelemente, da die beiden Sensorelemente prinzipiell identisch aufgebaut sein können und sich nur durch ein oder mehrere zusätzliche Filter für die zweiten Sensorelemente voneinander unterscheiden.

Für die Temperaturbestimmung nach dem Quotientenverfahren macht sich die neue Schaltungsanordnung zunutze, dass der erste und der zweite Wellenlängenbereich, die mit den ersten und zweiten Sensorelementen aufgenommen werden, verschieden voneinander sind. Infolgedessen liefern die ersten und zweiten Sensorelemente unterschiedliche elektrische Signale, selbst wenn sie auf ein und denselben Punkt innerhalb der beobachteten Szene ausgerichtet sind. Die unterschiedlichen Signale ermöglichen die Temperaturbestimmung nach dem Quotientenverfahren, obwohl der erste und der zweite Wellenlängenbereich im Bereich der Infrarotstrahlung überlappen.

Ein Kantenfilter im Sinne dieser Ausgestaltung ist ein Filter, das einen Transmissionssprung verursacht, der die untere Grenze des zweiten Wellenlängenbereichs definiert. Vorzugsweise liegt die untere Grenze zwischen etwa 660 nm und etwa 740 nm, vorzugsweise zwischen etwa 680 nm und etwa 720 nm, und besonders bevorzugt im Bereich von etwa 700 nm. Die angegebenen Wellenlängen und Wellenlängenbereiche sind bevorzugt, weil sie sich einerseits kostengünstig realisieren lassen und andererseits gute Messergebnisse insbesondere für die Temperaturbestimmung liefern. Die Verwendung eines Kantenfilters ermöglicht eine sehr einfache und kostengünstige Realisierung der zweiten Sensorelemente auf demselben Halbleitersubstrat, auf dem die ersten Sensorelemente angeordnet sind.

Die untere Grenze liegt im Wesentlichen mittig zu dem ersten Wellenlängenbereich. Dies trägt zu einer einfachen und kostengünstigen Herstellung der neuen Schaltungsanordnung bei. Außerdem lassen sich mit dieser Ausgestaltung sehr gute Messergebnisse erreichen. Von Vorteil ist hier, dass sich die Energieverteilungen in den beiden gebildeten Wellenlängenbereichen sehr gut für die Quotientenbildung eignen, da die detektierbaren Energien bei höheren Wellenlängen zunehmen.

Die oben genannte Aufgabe ist daher vollständig gelöst.

In einer bevorzugten Ausgestaltung besitzt die neue Schaltungsanordnung einen Schaltungsteil, der dazu ausgebildet ist, eine Temperatur der Szene in Abhängigkeit von den ersten und zweiten Signalen zu bestimmen.

In dieser Ausgestaltung erhält der Schaltungsteil die ersten und zweiten elektrischen Signale und er führt eine Quotientenbildung durch, um Emissionseigenschaften von Oberflächen in der beobachteten Szene zu eliminieren. Dieses an sich bekannte Verfahren zur Bestimmung der Temperatur einer strahlenden Oberfläche lässt sich mit der neuen Schaltungsanordnung in sehr einfacher und kostengünstiger Weise realisieren. In der bevorzugten Ausgestaltung ist der Schaltungsteil zur Bestimmung der Temperatur ein Teil der neuen Schaltungsanordnung. Alternativ hierzu könnte die neue Schaltungsanordnung jedoch auch separat von dem Schaltungsteil verwendet werden, beispielsweise zur zeitgleichen Aufnahme von visuellen Bildern und Infrarotbildern.

In einer weiteren Ausgestaltung beinhaltet die neue Schaltungsanordnung ein Halbleitersubstrat, auf dem eine Vielzahl von ersten und zweiten Sensorelementen nebeneinander angeordnet sind.

Vorzugsweise sind die ersten und zweiten Sensorelemente matrixartig nebeneinander angeordnet. Sie bilden einen flächigen Bildsensor mit einer Vielzahl von Pixeln. Die ersten und zweiten Sensorelemente können abwechselnd nach Art eines Schachbrettmusters an der Oberfläche des Halbleitersubstrats angeordnet sein. In anderen Ausführungsbeispielen wechseln sich die ersten und zweiten Sensorelemente zeilen- oder spaltenweise ab. Diese Ausgestaltungen ermöglichen eine schnelle und zeitsynchrone Aufnahme von flächigen Bildern einer beobachteten Szene sowohl im Bereich des sichtbaren Lichts als auch im Infrarotbereich. Durch die zeitsynchrone Aufnahme ist eine gute Zuordnung der verschiedenen Bilder zueinander möglich.

In einer weiteren Ausgestaltung sind die ersten und zweiten Sensorelemente jeweils übereinander angeordnet.

Diese Ausgestaltung kann die neue Schaltungsanordnung für sich genommen weiterbilden, aber auch in Kombination mit der vorhergehenden Ausgestaltung sehr vorteilhaft verwendet werden. Im erstgenannten Fall besitzt die neue Schaltungsanordnung lediglich ein oder wenige erste und zweite Sensorelemente, die beispielsweise für eine punktuelle, selektive Messung in einer Szene verwendet werden können. Im zweiten Fall sind eine Vielzahl von ersten und zweiten Sensorelementen, die jeweils stapelweise übereinander angeordnet sind, matrixartig nebeneinander angeordnet. Jedes Paar aus erstem und zweitem Sensorelement bildet hier gemeinsam ein Pixel des Matrixsensors. Die zuletzt genannte Ausgestaltung ermöglicht eine sehr hohe Auflösung. Von Vorteil ist, dass die Materiallagen, die das oben liegende Sensorelement jedes Stapels bilden, bereits eine Filterwirkung in Bezug auf die Strahlung haben, die das unten liegende Sensorelement erreicht. Außerdem können alle Sensorelemente in gemeinsamen Prozessschritten hergestellt werden, was die Herstellung der neuen Schaltungsanordnung insgesamt vereinfacht. Aber auch wenn die neue Schaltungsanordnung nicht für einen Matrixsensor verwendet wird, ermöglicht diese Ausgestaltung einen sehr kleinen Sensor, mit dem die ersten und zweiten Sensorelemente auf identische Messpunkte innerhalb der beobachteten Szene ausgerichtet werden können.

In einer weiteren bevorzugten Ausgestaltung beinhalten die ersten und zweiten Sensorelemente jeweils eine Photodiode und zumindest einen MOS-Transistor mit einem Gateanschluss, zwei weiteren Anschlüssen und einem Kanal, wobei die Photodiode mit dem MOS-Transistor so gekoppelt ist, dass in der Photodiode generierte Ladungsträger durch den Kanal abfließen, und wobei der Gateanschluss mit einem der zwei weiteren Anschlüsse leitend verbunden ist.

In dieser Ausgestaltung sind die ersten und zweiten Sensorelemente insbesondere nach dem HDRC-Prinzip aufgebaut, wie es in der eingangs genannten DE 42 09 536 A1 beschrieben ist. Der MOS-Transistor wird hier vorteilhafterweise im Sub-Threshold-Bereich betrieben, so dass die Sensorelemente jeweils eine logarithmische Kennlinie besitzen. Diese Ausgestaltung besitzt mehrere Vorteile. Einerseits macht sie es möglich, die für die Temperaturbestimmung vorteilhafte Quotientenbildung durch eine Differenzbildung zu ersetzen, weil die Differenz von logarithmierten Signalen dem Logarithmus des Quotienten der Signale entspricht. Eine Differenzbildung ist einfacher und schneller zu realisieren als eine "echte" Quotientenbildung. Darüber hinaus besitzt diese Ausgestaltung den Vorteil, dass die ersten und zweiten Sensorelemente eine sehr große Eingangsdynamik bis hin zu 120 dB besitzen. Mit anderen Worten können die ersten und zweiten Sensorelemente elektromagnetische Strahlung mit sehr geringer Intensität und auch mit sehr hoher Intensität detektieren und verarbeiten. Dies ist von großem Vorteil für ein bildgebendes Pyrometer, weil die hohe Signaldynamik es möglich macht, sehr helle, strahlungsintensive Objekte in direkter Nachbarschaft zu dunklen, strahlungsarmen Objekten oder Flächen aufzunehmen. Besonders vorteilhaft ist es, wenn die neue Schaltungsanordnung auch eine primäre Signalverarbeitung der ersten und zweiten Signale auf demselben Halbleiterchip beinhaltet, auf dem auch die ersten und zweiten Sensorelemente realisiert sind. Vorteilhafterweise beinhaltet die primäre Signalverarbeitung eine Analog-DigitalWandlung, so dass am Ausgang des Sensors digitale erste und zweite Signale für eine Weiterverarbeitung zur Verfügung stehen. Insgesamt ermöglicht diese Ausgestaltung eine sehr genaue Bildaufnahme und Temperaturmessung über einen sehr großen Dynamikbereich hinweg.

In einer weiteren Ausgestaltung ist das Kantenfilter ein dielektrisches Interferenzfilter mit einer Vielzahl von übereinander angeordneten Materiallagen, wobei diese Materiallagen im Wesentlichen aus Silizium und Siliziumnitrid gebildet sind. In einem bevorzugten Ausführungsbeispiel besteht das Interferenzfilter aus zwei Siliziumnitridschichten, zwischen denen eine Siliziumschicht angeordnet ist.

Diese Ausgestaltung ermöglicht eine sehr einfache und kostengünstige Herstellung des Interferenzfilters innerhalb einer Prozessfolge, mit der auch die ersten und zweiten Sensorelemente auf einem Halbleitersubstrat hergestellt werden. Ein Kantenfilter mit der angegebenen Schichtfolge aus Siliziumnitrid und Silizium lässt sich sehr einfach und kostengünstig herstellen und hat in Ausführungsbeispielen der Erfindung sehr gute Messergebnisse ermöglicht.

In einer weiteren Ausgestaltung besitzt die neue Schaltungsanordnung zumindest ein weiteres temperaturempfindliches Sensorelement, das gegen die elektromagnetische Strahlung aus dem ersten und zweiten Wellenlängenbereich abgeschirmt ist.

In bevorzugten Ausführungsbeispielen ist das weitere temperaturempfindliche Sensorelement eine Diode, die von einem Messstrom durchflossen ist. Das temperaturempfindliche Verhalten dieser Diode ermöglicht es, eine temperaturabhängige Drift der ersten und zweiten Sensorelemente zu korrigieren, indem die ersten und zweiten Signale in Bezug auf die Temperatur kalibriert werden. Besonders vorteilhaft ist es, wenn das weitere temperaturempfindliche Sensorelement mit Hilfe von einer oder mehreren Dioden realisiert wird, die häufig als so genannte Prozesskontrollstrukturen im Randbereich eines Bildsensors vorhanden sind. Es genügt, wenn man über einer solchen Prozesskontrollstruktur Materiallagen anordnet, die die elektromagnetische Strahlung aus dem ersten und zweiten Wellenlängenbereich abschirmen, wie etwa eine Metallisierung. In bevorzugten Ausführungsbeispielen wird die Temperaturkompensation der ersten und zweiten Signale in gleicher Weise durchgeführt, wie eine FPN-(Fixed Pattern Noise)Korrektur bei einem Bildsensor mit einer Vielzahl von matrixartig nebeneinander angeordneten Sensorelementen. Diese Ausgestaltung ermöglicht sehr hohe Messgenauigkeiten bei der Temperaturmessung.

Es versteht sich, dass die vorstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

Ausführungsbeispiele der Erfindung sind in der Zeichnung dargestellt und werden in der nachfolgenden Beschreibung näher erläutert. Es zeigen:
- Fig. 1: eine schematische Darstellung eines Ausführungsbeispiels der neuen Schaltungsanordnung,
- Fig. 2: ein Spektraldiagramm zur Erläuterung von bevorzugten Ausführungsbeispielen der neuen Schaltungsanordnung,
- Fig. 3: ein erstes Ausführungsbeispiel zur Realisierung der ersten und zweiten Sensorelemente,
- Fig. 4: ein weiteres Ausführungsbeispiel zur Realisierung der ersten und zweiten Sensorelemente, und
- Fig. 5: noch ein weiteres Ausführungsbeispiel zur Realisierung der ersten und zweiten Sensorelemente.

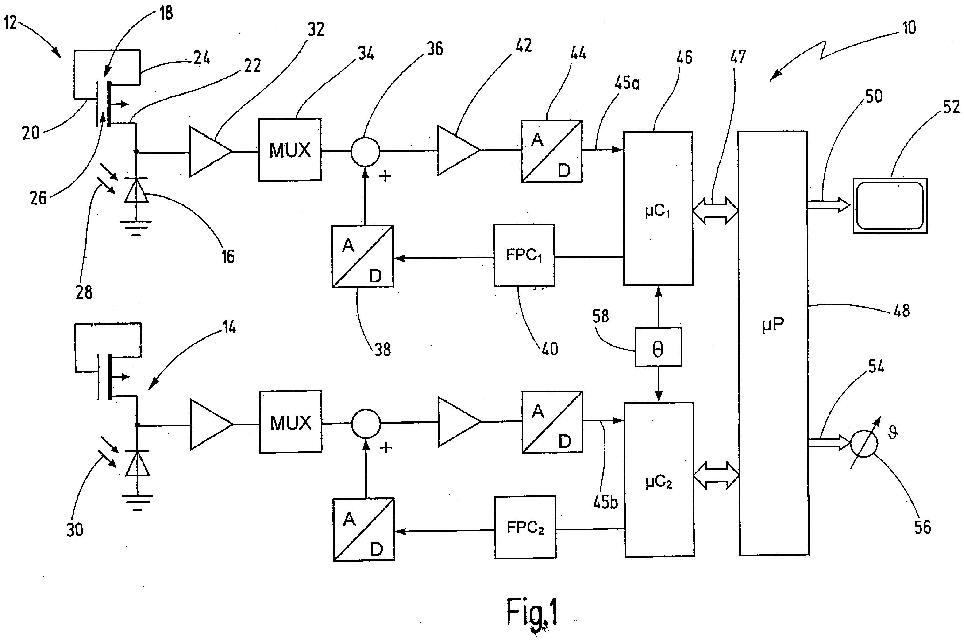

In Fig. 1 ist ein Ausführungsbeispiel der neuen Schaltungsanordnung in seiner Gesamtheit mit der Bezugsziffer 10 bezeichnet.

Die Schaltungsanordnung 10 ist hier mit einem ersten Sensorelement 12 und einem zweiten Sensorelement 14 dargestellt. Jedes dieser Sensorelemente besitzt eine Photodiode 16 und einen MOS-Transistor 18. Der MOS-Transistor 18 besitzt ein Gate 20 und zwei weitere Anschlüsse 22, 24, die üblicherweise als Source und als Drain bezeichnet werden. Im bevorzugten Ausführungsbeispiel sind der Gateanschluss 20 und der Drainanschluss 24 kurzgeschlossen. Der Sourceanschluss 22 ist mit der Kathode der Photodiode 16 verbunden. Aufgrund dieser Anordnung fließen Ladungsträger, die im Bereich des pn-Übergangs der Photodiode 16 durch auftreffende elektromagnetische Strahlung 28, 30 erzeugt werden, durch den Kanal 26 des MOS-Transistors 18 ab, und der MOS-Transistor 18 erzeugt eine Ausgangsspannung, deren Höhe logarithmisch von der Intensität der elektromagnetischer Strahlung abhängt.

Die Sensorelemente 12, 14 sind hier vereinfacht dargestellt. Weitere vorteilhafte Details sind in DE 42 09 536 A1 beschrieben, die das Grundprinzip der logarithmischen Bildzellen offenbart, das von der Anmelderin der vorliegenden Erfindung unter der Bezeichnung HDRC® vermarktet wird. In den bevorzugten Ausführungsbeispielen der vorliegenden Erfindung sind alle Sensorelemente nach diesem HDRC®-Prinzip aufgebaut. Grundsätzlich können die Sensorelemente jedoch auch auf andere Weise realisiert sein, beispielsweise als lineare CMOS-Bildzellen oder auch als CCD-Bildzellen.

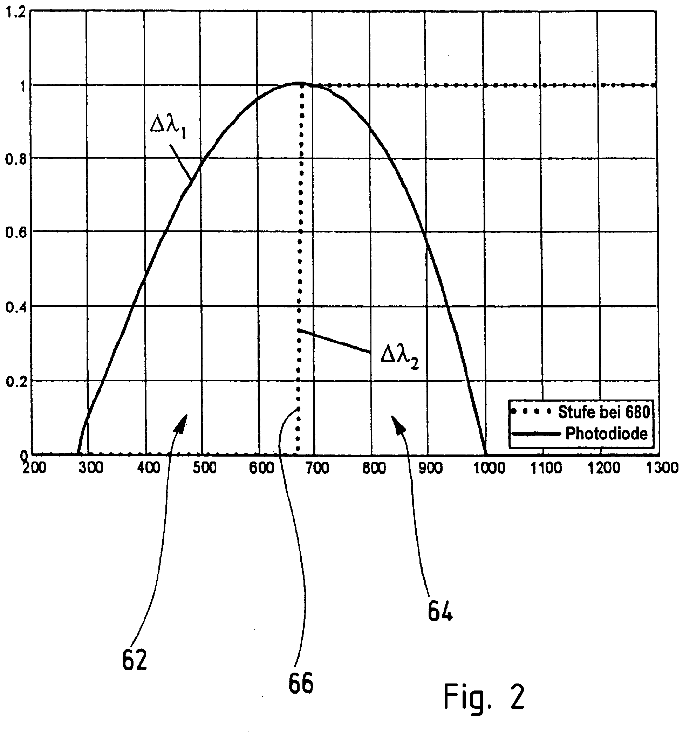

In Fig. 1 sind lediglich zwei Sensorelemente 12, 14 dargestellt. In bevorzugten Ausführungsbeispielen besitzt die neue Schaltungsanordnung 10 jedoch eine Vielzahl von ersten und zweiten Sensorelementen 12, 14, die in Fig. 1 der Einfachheit halber nicht dargestellt sind. Die Vielzahl der Sensorelemente 12, 14 ist in bevorzugten Ausführungsbeispielen auf einem Halbleitersubstrat angeordnet, wie dies nachfolgend anhand der Fig. 2 bis 4 erläutert ist.

In dem Ausführungsbeispiel gemäß Fig. 1 ist am Ausgang jedes Sensorelements 12, 14 ein Impedanzwandler 32 angeordnet, dessen Ausgang mit einem Multiplexer 34 verbunden ist. Mit Hilfe des Multiplexers 34 ist es möglich, eine Vielzahl von elektrischen Signalen einer gemeinsamen Signalverarbeitungsschaltung zuzuführen. In einem bevorzugten Ausführungsbeispiel, das in Fig. 1 dargestellt ist, wird ein erster Multiplexer 34 verwendet, um die elektrischen Signale der ersten Sensorelemente 12 zusammenzuführen, während ein zweiter Multiplexer dazu verwendet wird, um die elektrischen Signale der zweiten Sensorelemente 14 zusammenzuführen. In bevorzugten Ausführungsbeispielen besitzt die neue Schaltungsanordnung 10 zwei parallele Signalverarbeitungskanäle, wobei der eine Signalverarbeitungskanal die elektrischen Signale der ersten Sensorelemente 12 verarbeitet, während der andere Signalverarbeitungskanal die elektrischen Signale der Sensorelemente 14 verarbeitet. Bevorzugt sind die beiden Signalverarbeitungkanäle gleich aufgebaut, weshalb im Folgenden nur der Signalverarbeitungskanal für die ersten Sensorelemente 12 näher erläutert ist.

Der Ausgang des Multiplexers 34 ist mit einem Addierer 36 verbunden. Der Addierer 36 erhält von einem D/A-Wandler 38 ein weiteres elektrisches Signal, das in an sich bekannter Weise zur Korrektur von Fixed Pattern Noise dient. Fixed Pattern Noise bezeichnet ein Bildrauschen, das bei einem Bildsensor mit einer Vielzahl von Sensorelementen auftreten kann, weil die elektrischen Eigenschaften der einzelnen Sensorelemente aufgrund von Fertigungstoleranzen variieren können. Das Fixed Pattern Noise lässt sich korrigieren, indem man jeweils ein individuelles Korrektursignal zu den elektrischen Signalen der einzelnen Sensorelemente addiert. Das Korrektursignal ist so ausgewählt, dass die elektrischen Eigenschaften der einzelnen Sensorelemente aneinander angeglichen werden. Korrekturkoeffizienten zum Erzeugen dieser Korrektursignale sind hier in einem Speicher 40 hinterlegt, der mit einem D/A-Wandler 38 verbunden ist. Der D/A-Wandler 38 erzeugt anhand der Korrekturkoeffizienten aus dem Speicher 40 die Korrektursignale für jedes Sensorelement.

Der Ausgang des Addierers 36 ist über einen Verstärker 42 mit einem A/D-Wandler 44 verbunden, der die korrigierten analogen Signale der einzelnen Sensorelemente in entsprechende digitale Signale 45 umwandelt. Die digitalen Signale 45 werden einem Mikrocontroller 46 zugeführt. Anstelle eines Mikrocontrollers kann auch ein ASIC, ein FPGA oder ein anderer Signalverarbeitungsschaltkreis verwendet werden. Der Mikrocontroller 46 dient hier auch dazu, die Korrekturkoeffizienten für die FPN-Korrektur in den Speicher 40 zu schreiben.

Der Mikrocontroller 46 ist hier über eine Schnittstelle 47 mit einem Prozessor 48 verbunden. Der Prozessor 48 erhält die elektrischen Signale 45 aller ersten und zweiten Sensorelemente 12, 14 und berechnet daraus unter anderem Temperaturwerte nach dem bekannten Quotientenverfahren. An einem Ausgang 50 stellt der Prozessor 48 digitale Signale zur Anzeige auf einem Bildschirm 52 zur Verfügung. In bevorzugten Ausführungsbeispielen dient der Bildschirm 52 dazu, ein optisches Bild der betrachteten Szene im sichtbaren Wellenlängenbereich anzuzeigen. An einem Ausgang 54 stellt der Prozessor 48 Signale bereit, die die berechneten Temperaturen repräsentieren. Der Ausgang 54 kann mit einer weiteren Anzeige 56 verbunden sein. Alternativ hierzu können die Bilddaten und Temperaturwerte auch wechselweise oder gemeinsam auf dem Bildschirm 52 angezeigt werden.

Mit der Bezugsziffer 58 ist ein weiteres temperaturempfindliches Sensorelement bezeichnet, das in bevorzugten Ausführungsbeispielen gegen elektromagnetische Strahlung 28, 30 abgeschirmt ist. Für den Fall, dass die ersten und zweiten Sensorelemente 12, 14 Bildzellen (Pixel) eines Matrix-Bildsensors sind, ist es bevorzugt, wenn das weitere Sensorelement 58 in Form einer oder mehrerer Dioden realisiert ist, die im Randbereich der lichtempfindlichen Fläche des Sensors angeordnet sind. Das weitere Sensorelement 58 erzeugt eine Temperaturinformation, die für die Eigentemperatur des Sensors repräsentativ ist. Diese Temperaturinformation wird in bevorzugten Ausführungsbeispielen der neuen Schaltungsanordnung von den Controllern 46 verwendet, um die elektrischen Signale 45 der einzelnen Sensorelemente 12, 14 rechnerisch so zu korrigieren, dass Signalveränderungen aufgrund von Temperaturdrift der einzelnen Sensorelemente kompensiert sind.

Entsprechend der bevorzugten Verwendung der neuen Schaltungsanordnung für ein bildgebendes Pyrometer sind die ersten und zweiten Sensorelemente 12, 14 zur Aufnahme von elektromagnetischer Strahlung 28, 30 aus verschiedenen Wellenlängenbereichen ausgebildet. In dem bevorzugten Ausführungsbeispiel sind die ersten Sensorelemente 12 so ausgebildet, dass sie elektromagnetische Strahlung 28 aus einem ersten Wellenlängenbereich 62 aufnehmen, der in dem Diagramm in Fig. 2 mit einer durchgezogenen Linie dargestellt ist. In einem bevorzugten Ausführungsbeispiel beinhaltet der erste Wellenlängenbereich 62 Wellenlängen von etwa 280 nm bis etwa 1.000 nm. Die maximale Transmission dieses ersten Wellenlängenbereichs liegt bei etwa 680 nm. Eine solche Transmissionscharakteristik der ersten Sensorelemente ergibt sich, wenn die Photodioden 16 der ersten Sensorelemente 12 als oberflächennahe pn-Übergänge in einem Silizium-Halbleitermaterial realisiert sind. Diese Grenzen sind jedoch nicht exakt festgelegt, sondern hängen von den verwendeten Materialen und Prozessbedingungen ab. In bevorzugten Ausführungsbeispielen der neuen Schaltungsanordnung ist der erste Wellenlängenbereich 62 derjenige Wellenlängenbereich, der sich aufgrund der spektralen Empfindlichkeit von Silizium-Photodioden ergibt, die ohne spezielle Filter realisiert sind.

Die zweiten Sensorelemente 14 sind dazu ausgebildet, elektromagnetische Strahlung 30 aus einem zweiten Wellenlängenbereich 64 aufzunehmen, der von dem ersten Wellenlängenbereich 62 verschieden ist. In einem bevorzugten Ausführungsbeispiel ist der zweite Wellenlängenbereich die "obere Hälfte" des ersten Wellenlängenbereichs 62. Der zweite Wellenlängenbereich 64 ergibt sich in den bevorzugten Ausführungsbeispielen dadurch, dass die Photodioden der zweiten Sensorelemente 14 mit einem zusätzlichen Kantenfilter versehen sind, dessen Transmissionscharakteristik in Fig. 2 bei der Punktlinie 66 dargestellt ist. Der Transmissionssprung (cut on) liegt hier bei etwa 680 nm. Elektromagnetische Strahlung mit Wellenlängen von unter 680 nm wird von dem Kantenfilter unterdrückt. Nur elektromagnetische Strahlung mit Wellenlängen oberhalb von etwa 680 nm erreicht die Photodioden der zweiten Sensorelemente 14.

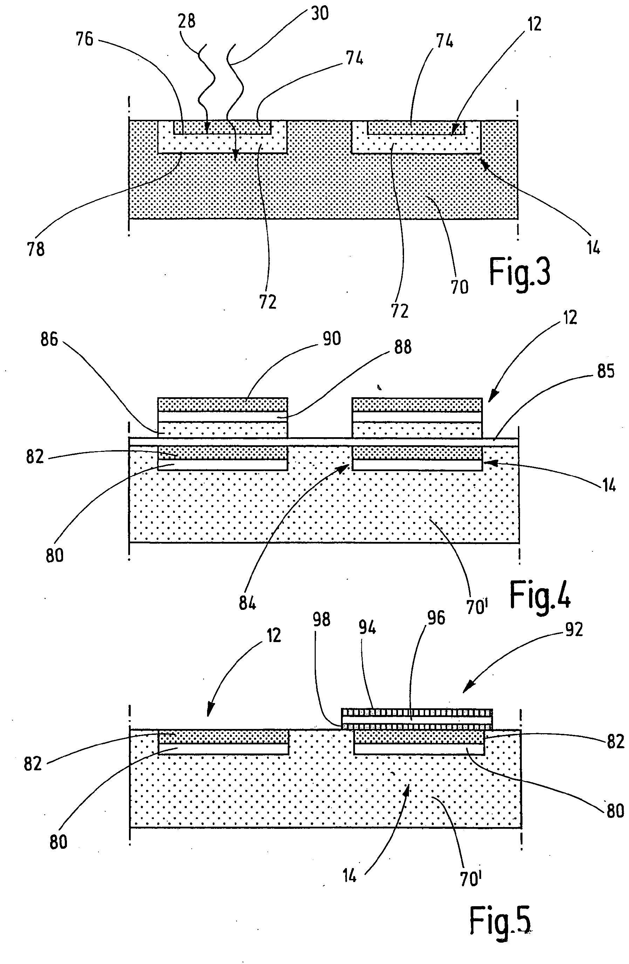

Fig. 3 zeigt ein erstes Ausführungsbeispiel zur Realisierung der Sensorelemente 12, 14. Gleiche Bezugszeichen bezeichnen dieselben Elemente wie zuvor.

Fig. 3 zeigt einen Ausschnitt aus einem Halbleitersubstrat 70, das im Querschnitt dargestellt ist. Beispielsweise ist das Halbleitersubstrat 70 hier ein p-dotiertes Siliziumsubstrat oder eine p-dotierte Wanne in einem Halbleitersubstrat. In dem p-dotierten Substrat 70 sind n-dotierte Inseln 72 angeordnet. An der Oberseite jeder Insel 72 ist eine weitere p-dotierte Schicht 74 angeordnet. Infolgedessen ergeben sich zwei pn-Übergänge 76, 78, wobei der pn-Übergang 76 oberhalb des pn-Übergangs 78 liegt. Der pn-Übergang 76 bildet die Photodiode 16 des ersten Sensorelements 12, während der pn-Übergang 78 die Photodiode 16 des zweiten Sensorelements 14 bildet. Die langwelligere Strahlung 30 dringt tiefer in das Halbleitermaterial ein und erreicht somit den tieferen pn-Übergang 78, während die kurzwelligere Strahlung 28 nur den oberen pn-Übergang 76 erreicht. In diesem Ausführungsbeispiel bilden die Schichten des oberen pn-Übergangs 76 ein Filter für den unteren pn-Übergang 78. Die Lage der pn-Übergänge 76, 78 wird hier in Abhängigkeit von der Eindringtiefe der zu detektierenden Strahlung gewählt. Wie in Fig. 3 dargestellt ist, sind mehrere solcher übereinander gestapelten Photodioden nebeneinander in dem Halbleitersubstrat 70 angeordnet. In diesem Ausführungsbeispiel bilden die Sensorelemente 12, 14 jeweils gemeinsam die einzelnen Pixel des Matrixsensors. Es versteht sich, dass jedes Pixel außerdem die MOS-Transistoren und - in bevorzugten Ausführungsbeispielen - weitere Bauelemente, wie etwa den Impedanzwandler 32, beinhaltet. Diese weiteren Bauelemente sind hier der Einfachheit halber nicht dargestellt.

Fig. 4 zeigt ein weiteres Ausführungsbeispiel, wie übereinander gestapelte erste und zweite Sensorelemente 12, 14 realisiert werden können. In diesem Ausführungsbeispiel sind die Sensorelemente 12, 14 beispielhaft auf einem n-dotierten Substrat 70' realisiert. In dem n-dotierten Substrat 70' sind eine Vielzahl von selbstleitenden Schichten 80 angeordnet, über denen p-dotierte Schichten 82 liegen. Auf diese Weise wird eine Vielzahl von pin-Dioden 84 gebildet, die als Photodioden für die zweiten Sensorelemente 14 dienen. Über den pin-Dioden 84 ist eine durchgehende Isolationsschicht 85 aus Siliziumdioxid angeordnet. Auf der Isolationsschicht 85 ist eine Vielzahl von weiteren pin-Dioden mit einer Schichtfolge aus n-dotiertem Silizium 86, selbstleitendem Silizium 88 und p-dotiertem Silizium 90 angeordnet. Die pin-Dioden mit der Schichtfolge 86, 88, 90 bilden die ersten Sensorelemente 12. Vorzugsweise sind die Schichten 86, 88, 90 mit Hilfe eines CVD-Verfahrens hergestellt. Eine Realisierung gemäß dem Ausführungsbeispiel in Fig. 4 besitzt den Vorteil, dass die Photodioden der Sensorelemente 12, 14 übereinander gestapelt sind, jedoch durch die Isolationsschicht 85 elektrisch voneinander getrennt sind. Die Photodioden der beiden Sensorelemente 12, 14 sind durch die Isolation potentialfrei und können daher beliebig verschaltet werden. Demgegenüber bilden die Inseln 72 in dem Ausführungsbeispiel gemäß Fig. 3 einen gemeinsamen Kathodenanschluss der beiden Photodioden für die Sensorelemente 12, 14.

Fig. 5 zeigt ein weiteres Ausführungsbeispiel, in dem die Photodioden der Sensorelemente 12, 14 nicht vertikal übereinander, sondern horizontal nebeneinander angeordnet sind. In diesem Fall sind die Photodioden der Sensorelemente 12, 14 weitgehend identisch aufgebaut. Im dargestellten Ausführungsbeispiel handelt es sich wieder um pin-Photodioden mit Schichten 80, 82, die in einem n-dotierten Siliziumsubstrat 70" angeordnet sind. Um die unterschiedlichen spektralen Empfindlichkeiten zu erreichen, ist über den Photodioden für die zweiten Sensorelemente 14 jeweils ein Filter 92 angeordnet, dessen Filtercharakteristik der Punktlinie 66 aus Fig. 2 entspricht. In bevorzugten Ausführungsbeispielen ist das Filter 92 als dielektrisches Interferenzfilter realisiert, und es besitzt eine obere Schicht 94 aus Siliziumnitrid, eine mittlere Schicht 96 aus Silizium, und eine untere Schicht 98 aus Siliziumnitrid. Die Schichten 94 bis 98 können wiederum mit Hilfe eines CVD-Verfahrens erzeugt werden.

In Ausführungsbeispielen gemäß Fig. 5 können die Sensorelemente 12, 14 nach Art eines Schachbrettmusters oder zeilenweise oder spaltenweise abwechselnd an der Oberfläche des Halbleitersubstrats 70' angeordnet sein. Im Vergleich zu einem Sensor nach den Ausführungsbeispielen gemäß Fig. 3 oder 4 ist die Auflösung geringer. Jedes Sensorelement 12, 14 bildet hier ein eigenes Pixel des Matrixsensors. Andererseits lassen sich die Sensorelemente 12, 14 hier in gemeinsamen Prozessschritten herstellen. Zum Abschluss der Prozessfolge genügt es, wenn die Photodioden der zweiten Sensorelemente 14 mit den Schichten 94 bis 98 bedeckt werden.

## Patentansprüche

1. Schaltungsanordnung zum Erzeugen von licht- und temperaturabhängigen Signalen (45), die Eigenschaften einer Szene repräsentieren, mit Sensorelementen (12, 14), die in Abhängigkeit von auftreffender elektromagnetischer Strahlung (28, 30) eine Anzahl von ersten und zweiten elektrischen Signalen (45a, 45b) erzeugen, wobei die ersten elektrischen Signale (45a) in Abhängigkeit von elektromagnetischer Strahlung (28) aus einem ersten Wellenlängenbereich (62) erzeugt sind, der zumindest einen großen Teil des sichtbaren Lichts enthält, und wobei die zweiten elektrischen Signale (45b) in Abhängigkeit von elektromagnetischer Strahlung (30) aus einem zweiten Wellenlängenbereich (64) erzeugt sind, der überwiegend Infrarotstrahlung enthält, wobei der erste Wellenlängenbereich (62) den zweiten Wellenlängenbereich (64) überlappt und somit ebenfalls Infrarotstrahlung enthält, **dadurch gekennzeichnet, dass** die Sensorelemente eine Anzahl von ersten (12) und zweiten (14) Sensorelementen enthält, wobei die ersten und zweiten Sensorelemente (12, 14) zwei verschiedene Arten von Sensorelementen sind, da sie zur Aufnahme von elektromagnetischer Strahlung (28, 30) aus verschiedenen Wellenlängenbereichen ausgebildet sind, wobei der erste Wellenlängenbereich (62) den zweiten Wellenlängenbereich (64) weitgehend vollständig überlappt,
wobei das zweite Sensorelement (14) ein Kantenfilter (92) beinhaltet, das eine untere Grenze (66) des zweiten Wellenlängenbereichs (64) definiert, und wobei die untere Grenze (66) im Wesentlichen mittig zu dem ersten Wellenlängenbereich (62) liegt.

2. Schaltungsanordnung nach Anspruch 1, **gekennzeichnet durch** einen Schaltungsteil (48), der dazu ausgebildet ist, eine Temperatur der Szene in Abhängigkeit von den ersten und zweiten Signalen (45a, 45b) zu bestimmen.

3. Schaltungsanordnung nach Anspruch 1 oder 2, **gekennzeichnet durch** ein Halbleitersubstrat (70), auf dem eine Vielzahl von ersten und zweiten Sensorelementen (12, 14) nebeneinander angeordnet sind.

4. Schaltungsanordnung nach einem der Ansprüche 1 bis 3, **dadurch gekennzeichnet, dass** die ersten und zweiten Sensorelemente (12, 14) jeweils übereinander angeordnet sind.

5. Schaltungsanordnung nach einem der Ansprüche 1 bis 4, **dadurch gekennzeichnet, dass** die ersten und zweiten Sensorelemente (12, 14) jeweils eine Photodiode (16) und zumindest einen MOS-Transistor (18) mit einem Gateanschluss (20), zwei weiteren Anschlüssen (22, 24) und einem Kanal (26) beinhalten, wobei die Photodiode (16) mit dem MOS-Transistor (18) so gekoppelt ist, dass in der Photodiode (16) generierte Ladungsträger durch den Kanal (26) abfließen, und wobei der Gateanschluss (20) mit einem der zwei weiteren Anschlüsse (24) leitend verbunden ist.

6. Schaltungsanordnung nach einem der Ansprüche 1 bis 5, **dadurch gekennzeichnet, dass** das Kantenfilter (92) ein dielektrisches Interferenzfilter mit einer Vielzahl von übereinander angeordneten Materiallagen (94-98) ist, wobei die Materiallagen (94-98) im Wesentlichen aus Silizium und Siliziumnitrid gebildet sind.

7. Schaltungsanordnung nach einem der Ansprüche 1 bis 6, **gekennzeichnet durch** zumindest ein weiteres temperaturempfindliches Sensorelement (58), das gegen die elektromagnetische Strahlung aus dem ersten und zweiten Wellenlängenbereich (62, 64) abgeschirmt ist.

8. Verwendung einer Schaltungsanordnung nach einem der Ansprüche 1 bis 7 als Pyrometer, insbesondere als bildgebendes Pyrometer.

## Claims

1. A circuit arrangement for generating light- and temperature-dependent signals (45) which represent properties of a scene, comprising sensor elements (12, 14), which generate a number of first and second electrical signals (45a, 45b) that are dependent on impinging electromagnetic radiation (28, 30), wherein the first electrical signals (45a) are generated in a manner dependent on electromagnetic radiation (28) from a first wavelength range (62) comprising at least a large part of visible light, and wherein the second electrical signals (45b) are generated in a manner dependent on electromagnetic radiation (30) from a second wavelength range (64) predominantly comprising infrared radiation, wherein the first wavelength range (62) overlaps the second wavelength range (64) and therefore also comprises infrared radiation, **characterized in that** the sensors elements comprise a number of first (12) and second (14) sensor elements, wherein the first and second sensor elements (12, 14) are of different kind, since they are designed for recording of electromagnetic radiation (28, 30) from different wavelength ranges, wherein the first wavelength range (62) substantially completely overlaps the second wavelength range (64), wherein the second sensor element (14) comprises a cut-off filter (92), which defines a lower limit (66) of the second wavelength range (64), and wherein the lower limit (66) is located substantially centrally with respect to the first wavelength range (62).

2. The circuit arrangement of claim 1, **characterized by** a circuit part (48) designed to determine a temperature of the scene in a manner dependent on the first and second signals (45a, 45b).

3. The circuit arrangement of claim 1 or 2, **characterized by** a semiconductor substrate (70), on which a plurality of first and second sensor elements (12, 14) are arranged side by side.

4. The circuit arrangement of any of claims 1 to 3, **characterized in that** the first and second sensor elements (12, 14) are arranged one above the other.

5. The circuit arrangement of any of claims 1 to 4, **characterized in that** the first and second sensor elements (12,14) each comprise a photodiode (16) and at least one MOS transistor (18) having a gate terminal (20), two further terminals (22, 24) and a channel (26), wherein the photodiode (16) is coupled to the MOS transistor (18) in such a way that charge carriers generated in the photodiode (16) drain into the channel (26), and wherein the gate terminal (20) is conductively connected to one of the two further terminals (24).

6. The circuit arrangement of any of claims 1 to 5, **characterized in that** the cut-off filter (92) is a dielectric interference filter having a plurality of material layers (94-98) arranged one above another, wherein the material layers (94-98) are formed substantially from silicon and silicon nitride.

7. The circuit arrangement of any of claims 1 to 6, **characterized by** at least one further temperature-sensitive sensor element (58), which is shielded from the electromagnetic radiation from the first and second wavelength ranges (62, 64).

8. A method of using a circuit arrangement of any of claims 1 to 7 as a pyrometer, in particular as an imaging pyrometer.

## Revendications

1. Arrangement de circuit destiné à générer des signaux (45) dépendant de la lumière et de la température, lesquels représentent les propriétés d'une scène, comprenant des éléments de détection (12, 14) qui génèrent une pluralité de premiers et de deuxièmes signaux électriques (45a, 45b) en fonction d'un rayonnement électromagnétique (28, 30) incident, les premiers signaux électriques (45a) étant générés en fonction du rayonnement électromagnétique (28) issu d'une première plage de longueurs d'onde (62), laquelle contient au moins une grande partie de la lumière visible, et les deuxièmes signaux électriques (45b) étant générés en fonction du rayonnement électromagnétique (30) issu d'une deuxième plage de longueurs d'onde (64), laquelle contient principalement un rayonnement infrarouge, la première plage de longueurs d'onde (62) chevauchant la deuxième plage de longueurs d'onde (64) et contenant ainsi également un rayonnement infrarouge, **caractérisé en ce que** les éléments de détection contiennent une pluralité de premiers (12) et de deuxièmes (14) éléments de détection, les premiers et deuxièmes éléments de détection (12, 14) étant deux types différents d'éléments de détection qui sont configurés pour capter un rayonnement électromagnétique (28, 30) issu de plages de longueurs d'onde différentes, la première plage de longueurs d'onde (62) chevauchant largement entièrement la deuxième plage de longueurs d'onde (64),
le deuxième élément de détection (14) comportant un filtre à arêtes (92) qui définit une limite inférieure (66) de la deuxième plage de longueurs d'onde (64), et la limite inférieure (66) se trouvant sensiblement au centre par rapport à la première plage de longueurs d'onde (62).

2. Arrangement de circuit selon la revendication 1, **caractérisé par** une partie de circuit (48) qui est configurée pour déterminer une température de la scène en fonction des premiers et des deuxièmes signaux (45a, 45b).

3. Arrangement de circuit selon la revendication 1 ou 2, **caractérisé par** un substrat en semiconducteur (70) sur lequel sont disposés les uns à côté des autres une pluralité de premiers et deuxièmes éléments de détection (12, 14).

4. Arrangement de circuit selon l'une des revendications 1 à 3, **caractérisé en ce que** les premiers et deuxièmes éléments de détection (12, 14) sont respectivement disposés les uns au-dessus des autres.

5. Arrangement de circuit selon l'une des revendications 1 à 4, **caractérisé en ce que** les premiers et deuxièmes éléments de détection (12, 14) comportent respectivement une photodiode (16) et au moins un transistor MOS (18) doté d'une borne de gâchette (20), de deux bornes (22, 24) supplémentaires et d'un canal (26), la photodiode (16) étant connectée au transistor MOS (18) de telle sorte que les porteurs de charge générés dans la photodiode (16) s'échappent à travers le canal (26) et la borne de gâchette (20) étant reliée de manière conductrice avec l'une des deux bornes (24) supplémentaires.

6. Arrangement de circuit selon l'une des revendications 1 à 5, **caractérisé en ce que** le filtre à arêtes (92) est un filtre à interférence diélectrique comprenant une pluralité de couches de matière (94-98) disposées les unes au-dessus des autres, les couches de matière (94-98) étant pour l'essentiel constituées de silicium et de nitrure de silicium.

7. Arrangement de circuit selon l'une des revendications 1 à 6, **caractérisé par** au moins un élément de détection (58) sensible à la température supplémentaire qui est protégé par blindage contre le rayonnement électromagnétique issu de la première et de la deuxième plage de longueurs d'onde (62, 64).

8. Utilisation d'un arrangement de circuit selon l'une des revendications 1 à 7 en tant que pyromètre, notamment en tant que pyromètre d'imagerie.
